# EUROPEAN PATENT SPECIFICATION

(11) **EP 3 314 034 B1**
(45) Date of publication and mention of the grant of the patent: **14.10.2020**
(21) Application number: 16747614.2
(22) Date of filing: 28.06.2016
(51) Int. Cl.: C23C 14/24

(54) **EVAPORATION CRUCIBLE WITH FLOATER**
VERDAMPFUNGSTIEGEL MIT SCHWIMMER
CREUSET DE VAPORISATION AVEC FLOTTEUR

(30) Priority: 29.06.2015 US 201562186065 P
(43) Date of publication of application: 02.05.2018
(73) Proprietor: Flisom AG, 8155 Niederhasli (CH); Ruehle, Ulfert, 8600 Duebendorf (CH)
(72) Inventor: PFEIFFER, Reto, 8330 Pfaeffikon (CH)
(86) International application number: PCT/IB2016/000915
(87) International publication number: WO 2017/001910

(56) References cited:
- GB-A- 1 103 211
- JP-A- S5 896 872

## Description

### BACKGROUND

### Field

Embodiments of the present disclosure generally relate to linear evaporation sources used for vapor deposition of material onto substrates and more particularly for controlled material coating of large substrates, such as vacuum deposition on large sheets or using roll-to-roll processes.

### Description of the Related Art

Coating of objects using thermal evaporation, for example in photovoltaic cell fabrication such as CIGS (copper-indium-gallium-selenide) cell fabrication, requires a crucible to heat up and vaporize material that deposits onto a substrate positioned adjacent to the crucible. The deposition usually takes place within a vacuum chamber, thereby imposing spatial and physical constraints on the evaporation device and deposition system. Space may be especially constrained in the case of a roll-to-roll deposition system where the roll-to-roll mechanism must be contained within a desirably small vacuum chamber. Physical constraints can also be problematic in the case of coevaporation processes that use multiple adjacently positioned sources operating at different regulated temperatures to deposit a material layer with a desired distribution and thickness onto a moving substrate.

A source for vapor deposition of material onto a roll-to-roll web ordinarily comprises: an elongated crucible that contains the material to be vaporized, at least one electrical heating element, and optionally nozzles to direct the vaporized material flux onto the nearby moving web substrate. Several evaporation sources, also known as evaporation boats, may be arranged parallel to each other to deposit larger quantities of material and/or different materials onto the moving substrate.

It is often necessary to regulate the flux of material leaving the crucible to achieve a controlled deposition thickness along the length and the width of the moving substrate. The flux of material and its distribution is related to the crucible's temperature distribution and also to the distribution and shape of the openings or nozzles that let the evaporated material flow out of the crucible. The temperature distribution within a crucible is ordinarily spatially non-uniform, and therefore related to the electrical power delivered to the heating elements at various locations within the evaporation source's assembly. The material flux provided from each crucible to the substrate will tend to vary as the level of evaporated material changes within the crucible and temperature of the heated material varies within the crucible. The varying material flux will undesirably cause a drift in the deposition spatial uniformity and, in the co-evaporation case, the material composition of the deposited layer will vary over time.

An evaporation source is known from JP-58-96872.

Therefore, there is a need in the art for a crucible design that has an improved temperature distribution of the heated evaporation material and an improved control of flux of the evaporated material from the crucible.

### SUMMARY OF THE DISCLOSURE

Embodiments disclosed herein generally relate to linear evaporation sources used for vapor deposition of material onto substrates and more particularly for controlled material coating of large substrates, such as vacuum deposition on large sheets or using roll-to-roll processes. An evaporation source according to the present invention is disclosed in claim 1.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.
Figure 1A is a side cross-sectional view of a vapor deposition system according to one embodiment.
Figure 1B is a schematic diagram of an evaporation source according to one embodiment.
Figure 2A is a perspective view of an evaporation source according to one embodiment.
Figure 2B is a perspective view of an evaporation source according to one embodiment.
Figure 2C is a cross-sectional view of an evaporation source according to one embodiment.
Figure 2D is a perspective view of an evaporation source according to one embodiment.
Figure 2E is a cross-sectional view of an evaporation source according to one embodiment.
Figure 3A is a perspective view of an evaporation source according to another embodiment.
Figure 3B is a perspective view of an evaporation source according to another embodiment.
Figure 3C is a cross-sectional view of an evaporation source according to another embodiment.
Figure 3D is a cross-sectional view of an evaporation source according to another embodiment.
Figure 3E is a cross-sectional view of an evaporation source according to another embodiment.
Figure 4A is a cross-sectional view of a float according to one embodiment.
Figure 4B is a cross-sectional view of a float according to another embodiment.
Figure 4C is a cross-sectional view of a float according to another embodiment.
Figure 5A is a top view of a float according to one embodiment.
Figure 5B is a top view of a float according to another embodiment.
Figure 5C is a top view of a float according to another embodiment.
Figure 5D is a top view of a float not according to the invention.
Figure 5E is a cross-sectional view of a float not according to the invention.
Figure 5F is a cross-sectional view of a float not according to the invention.
Figure 5G is a cross-sectional view of a float according to another embodiment.
Figure 5H is a top view of a float according to another embodiment.
Figure 6A is a top view of a float not according to the invention.
Figure 6B is a top view of a float not according to the invention.
Figure 6C is a top view of a detail of a float not according to the invention.
Figure 6D is a cross-sectional view of a detail of a float not according to the invention.
Figures 7A-7E are cross-sectional views of a float channel

To facilitate understanding, identical reference numerals have been used, where possible, to designate identical elements that are common to the figures. It is contemplated that elements disclosed in one embodiment may be beneficially utilized on other embodiments without specific recitation.

### DETAILED DESCRIPTION

Embodiments of the disclosure provided herein generally include an apparatus and method of depositing a layer on a substrate in a processing system by use of a physical vapor deposition technique. Embodiments of the disclosure provided herein also relate to linear evaporation sources used for vapor deposition of material onto substrates and more particularly for controlled material coating of large substrates, such as vacuum deposition on roll-to-roll substrates. The apparatus and methods disclosed herein include the use of a material flux controlled evaporation source that is disposed within the processing region of a processing system. The material flux controlled evaporation source generally includes a material flux regulation device, also referred to herein as a float, that is configured to control a flux of an evaporated material from the evaporation source and improve the temperature uniformity within the evaporation source.

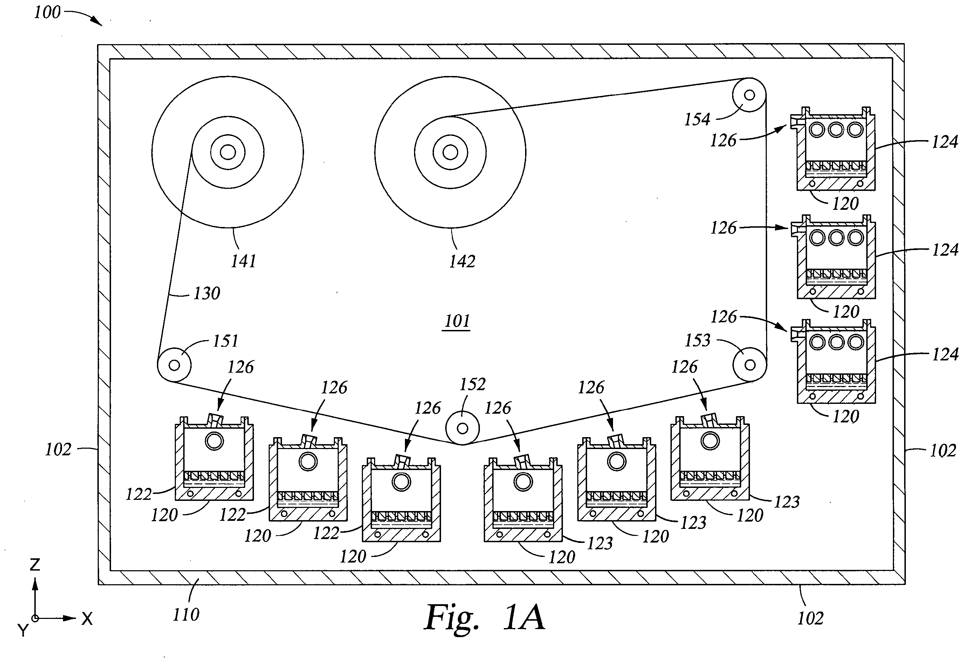

Figure 1A is a side cross-sectional view of a vapor deposition system 100 according to one embodiment. While not intending to limit the scope of the disclosure provided herein, in one embodiment, the vapor deposition system 100 is a roll-to-roll type vapor deposition system. The vacuum deposition chamber 110 includes one or more material flux controlled evaporation sources, hereinafter evaporation sources 120, which are disposed within a processing region 101 that is enclosed by one or more walls 102. Typically, the processing region 101 of the vacuum deposition chamber 110 is maintained at a constant vacuum pressure, such as about 2.5 Pa (e.g., -20 mTorr). One or more sets 122, 123, 124 of one or more evaporation sources 120 are positioned within the processing region 101 so that one or more evaporation source 120 can deposit a material layer onto a substrate as it is transferred through the processing region 101. In some embodiments, the substrate is a web 130 that may comprise a flexible polyimide or stainless steel material. The web 130 can be transferred through the processing region 101 as it is unwound from a pay-off roll 141 and delivered over tensioning rolls 151, 152, 153, 154 onto a take-up roll 142. The one or more evaporation sources 120 contain material that is heated to a molten state so that the heated material will evaporate to coat portions of the web 130 as the web 130 passes near the outlet 126 (or nozzles) of each of the one or more evaporation sources 120. Sets 122, 123, and 124 of evaporation sources 120 may be oriented so as to follow the path of web 130 through the processing region 101.

A person of ordinary skill in the art will recognize that any appropriate material may be deposited on a substrate using the vapor deposition system 100. The vapor deposition system 100 is particularly appropriate for deposition of materials to create photovoltaic cells, particularly CIGS (copper-indium-gallium-selenide) solar cells. In one example, at least one CIGS containing semiconductive photovoltaic layer, also known as the absorber layer, is deposited onto a portion of the web 130. The semiconductive photovoltaic layer may, for example, be made of an "ABC" material, wherein "A" represents elements in group 11 of the periodic table of chemical elements (e.g., copper (Cu) or silver (Ag)), "B" represents elements in group 13 of the periodic table (e.g., indium (In), gallium (Ga), or aluminum (Al)), and "C" represents elements in group 16 of the periodic table (e.g., sulfur (S), selenium (Se), or tellurium (Te)). An example of an ABC₂ material is the Cu(In,Ga)Se₂ semiconductor also known as a CIGS material. Other thin-film absorber materials include cadmium telluride (CdTe) and its variants, amorphous silicon, thin-film silicon, as well as absorber materials used to manufacture dye-sensitized solar cells or organic solar cells.

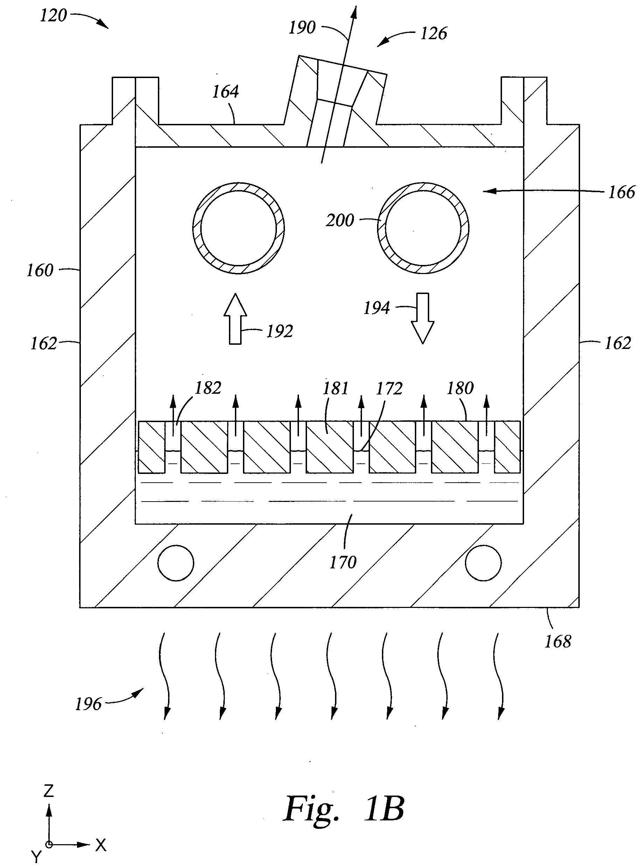

Figure 1B is a schematic diagram of evaporation source 120 according to one embodiment. The evaporation source 120 includes a crucible 160 that includes a lid 164 and one or more walls 162 that define an evaporation region 166 that contains some amount of material 170. The evaporation source 120 also includes a float 180 that is disposed within the evaporation region 166. The float 180 is disposed between the lid 164 and the material 170 disposed within the crucible base 168 of the evaporation source 120. A body 181 of the float 180 contains one or more channels 182 through which the material 170 flows during processing. As material 170 is heated by heating elements to be discussed below, material 170 becomes molten and then evaporates through channels 182 formed in float 180. Material 170 evaporates at a first evaporation flux 192 due to the heat provided from the heating elements. In a steady state evaporation process, a portion of the evaporation flux 192 exits through the outlet 126 in the lid 164 as a deposition flux 190 and a portion is reabsorbed into the pool of material 170 as a re-absorption flux 194. During processing, an amount of heat loss 196 occurs through the sides, top, and bottom of evaporation source 120. Heat may also be lost through at least one outlet 126 and via the deposition flux 190. The heat loss is ordinarily compensated by heat supplied by at least one heater assembly 200.

The presence of the float 180 at the material surface 172 of the material 170 may increase the homogeneity of the temperature distribution at the material surface 172. With a more homogeneous temperature distribution at the material surface, convective currents within the material 170 may also be more homogeneous, thereby reducing the probability that droplets of material are projected from the material 170 towards the evaporation region 166 or through the outlet 126. The float 180 is also used to help control the amount of the evaporation flux 192 that is generated by heating the material 170 during processing and help stabilize the thermal environment in the evaporation region 166 throughout all stages of the deposition process performed in the vapor deposition system 100. One will note that the various stages of the deposition process include when the evaporation source 120 contains a maximum amount of the material 170 (e.g., crucible is at a full level) and when the evaporation source 120 contains a minimum amount of material (e.g., crucible is at an empty level).

While not intending to be bound by theory, it is believed that by forming a float 180 that restricts the exposed area of the material surface 172 of the molten material 170 during processing, the amount of evaporation flux 192 generated from the molten material 170 can be controlled throughout the various stages of a deposition process performed in the vapor deposition system 100. The exposed area includes the open area created by the channels 182 formed through portions of the body 181 of the float 180. Therefore, by tailoring the amount of open area provided by the channels 182 and forming the float 180 so that it has a desired mass per unit volume, which allows the float 180 to remain at the material surface 172 of the material 170 during processing, the evaporation flux 192 can be controlled for a certain material 170 that is maintained at a controlled material evaporation temperature and set chamber pressure. A number of channel 182 configurations and designs are discussed in further detail below.

As noted above, the float 180 may also provide an ability to better control the heat flux to and from the surface 172 of the material 170. In this case, the float 180 can act as a device that is better able to absorb and/or reflect heat radiated from heating elements that are positioned above or a distance from the surface 172. In some embodiments, the material used to form the float 180 and/or the surface of the float 180 is able to absorb a significant portion of the radiation generated by a heating element that is coupled to a portion of the evaporation source 120.

In some embodiments, the thermal conductivity of the material used to form the body 181 of the float 180 is selected to cause the float 180 to remain at the surface 172 to improve the surface temperature uniformity of the material 170 at the surface 172. The material used to form the body 181 of the float 180 may be selected for a known evaporation material 170, so that it has a thermal conductivity that is greater than conductivity of the molten material 170 at the surface 172. The float 180 may have a lateral thermal conductivity (X-Y plane) that reduces temperature non-uniformity across the material surface 172, which may be created by the thermal environment within the evaporation region and/or heater arrangement in the evaporation source 120.

However, in some alternate embodiments, the material used to form the body 181 of the float 180 may be selected so that it has a thermal conductivity that is less than the conductivity of the molten material 170 at the surface 172 during processing. In this case, the float 180 may act as a thermal barrier that is able to reduce the heat lost through the surface 172 of the material 170. The reduction in the amount of heat lost through the surface 172 of the material 170 may be important where the evaporation source 120 is heated by heating elements that are positioned to heat the crucible base 168.

More generally, the float 180 may, in comparison to an evaporation source that does not include a float 180, reduce the amount of heat wastefully radiated by the evaporation source, for example towards a substrate. The float 180 may therefore reduce the amount of energy needed to operate an evaporation source 120. The float 180 may also reduce the amount of energy needed from the heater assembly 200 to melt the surface 172 of the material 170.

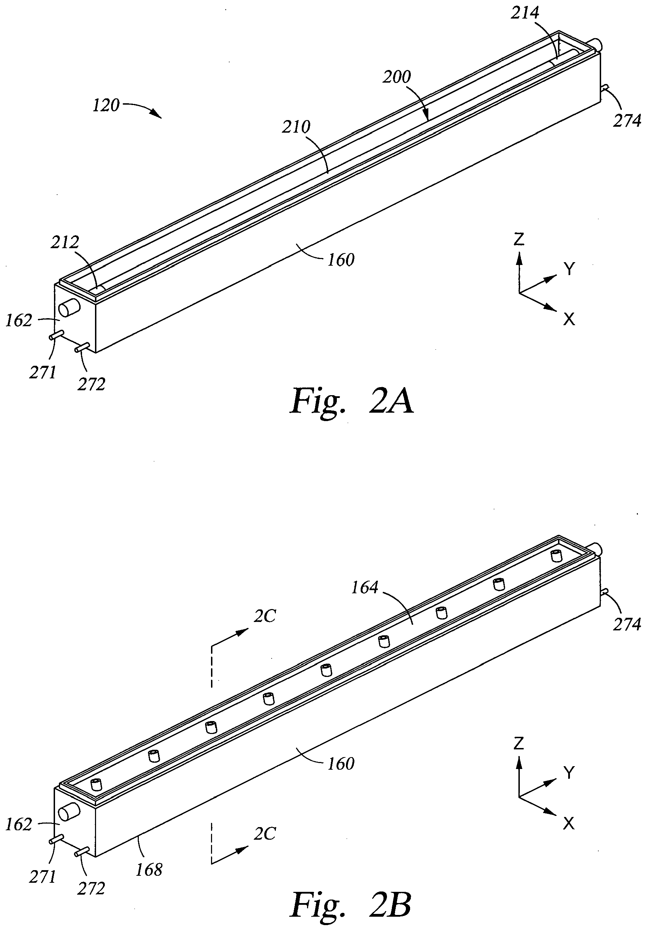

Figure 2A is a perspective view of evaporation source 120 according to one embodiment. Evaporation source 120 includes an elongated generally rectangular crucible 160 and one or more heater assemblies 200. Crucible 160 may be formed from a graphite material that is coated with a refractory metal such as cobalt or tungsten. In some embodiments, each heater assembly 200 may include one or more axially aligned heating rods 210. Each heating rod 210 may include opposing ends 212, 214. Each heating rod 210 may be supported at each end 212, 214 by passing through a support hole in a wall 162 of the crucible 160. In one embodiment, each heater assembly 200 is positioned close to the outlets 126 formed in the lid 164 of the crucible 160 (see Figure 1B), such that there is no contact between the heater assembly 200 and the material 170 to be evaporated present at the bottom of crucible 160 during ordinary operation. One or more heating rods 210 is powered via one or more pairs of insulated contacts (not shown). Evaporation source 120 may comprise one or more temperature sensors 271, 272 positioned near the lower surface of the crucible base 168 of the crucible 160. Each temperature sensor 271, 272, 274 may extend into the evaporation region 166 of crucible 160 to measure temperature of the material 170 to be evaporated. The number of temperature sensors 271, 272, 274 provided may be the same as the number of heating rods 210 provided such that each temperature sensor 271, 272, 274 may measure the temperature at a position under the mid-length of each heating rod 210. According to another embodiment, temperature sensors 271, 272, 274, may measure the temperature at a plurality of positions along the Y-axis of the crucible.

Figure 2B is a perspective view of evaporation source 120 according to another embodiment. Evaporation source 120 comprises crucible 160 covered in part by lid 164. Crucible 160 and lid 164 may be formed from a high temperature material, such as a graphite material that is coated with a refractory metal. In one example, the high temperature material may include alumina (Al₂O₃), silica (SiO₂), boron nitride (BN), graphite (C), molybdenum (Mo), tantalum (Ta), tungsten (W), or zirconium oxide (ZrO₂). Lid 164 may comprise one or more nozzles, or outlets 126. The lid may be coated, for example on its top side, with a material that may include platinum, tantalum, molybdenum, or tungsten.

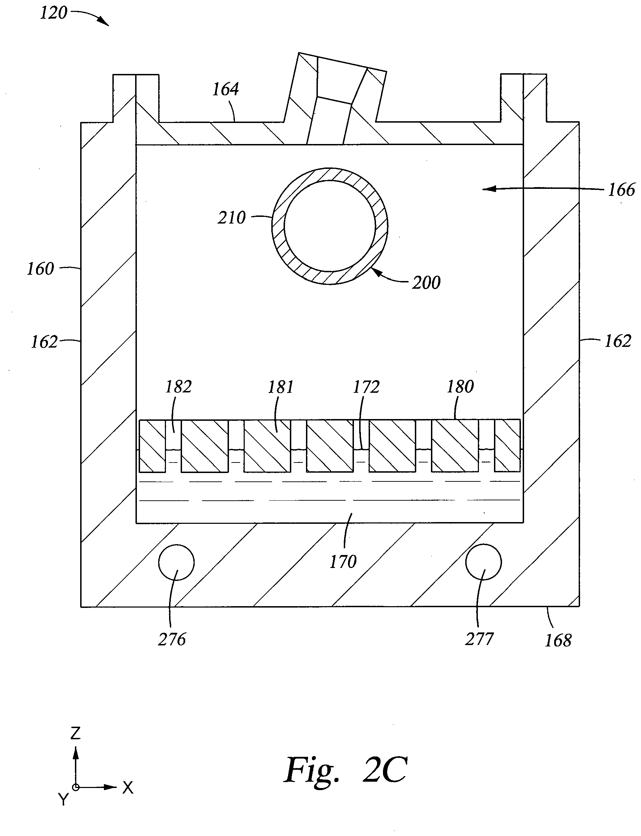

Figure 2C is a side cross-sectional view of evaporation source 120 according to one embodiment. The base 168 and lid 164 and walls 162 of the crucible 160 enclose the evaporation region 166 that includes the material 170. During operation the heater assembly 200 heats the material 170 via radiation so that the material 170 becomes molten. Material 170 may comprise a metal such as copper, indium, gallium, selenium, zinc, tin, gold, chrome, antimony, sodium, magnesium, aluminum, germanium, nickel, silver, cadmium, lead, or other material with a boiling point, or vaporization temperature, between 100°C to 2000°C at a desired vacuum chamber pressure. Lid 164 at least partially covers crucible 160.

A float 180 that includes a plurality of channels 182 is disposed over the surface of the material 170 enclosed by the crucible 160. In general, the float 180 comprises a material that has a mass density less than the mass density of molten material 170, allowing the float 180 to remain at or on the surface of the molten material 170 without becoming fully submerged in molten material 170. (See fuller discussion below.)

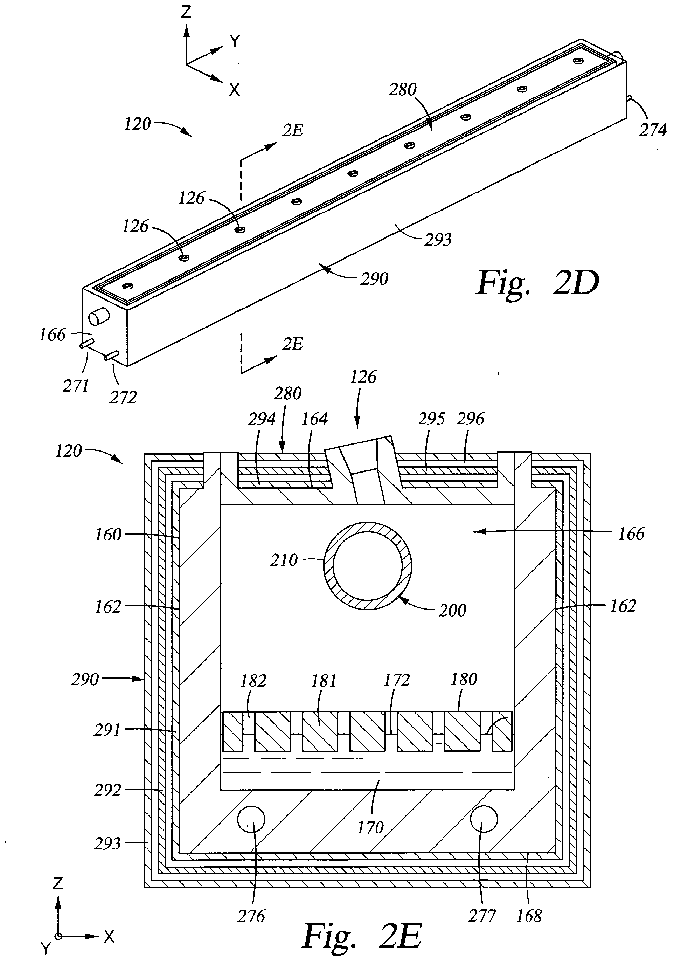

Figure 2D is a perspective view of one embodiment of the evaporation source 120 that includes one or more heat shield assemblies 280, 290. The one or more heat shield assemblies 280, 290 may comprise lid heat shield assembly 280 and crucible heat shield assembly 290. Figure 2D shows only the outer layer of the heat shield assemblies 280, 290. Lid outer shield 296 may be positioned on lid 164 leaving clearance for nozzles 126. Crucible outer shield 293 may be positioned to cover sides and bottom of crucible 160 and not to cover lid 164. Heat shield assemblies 280, 290 advantageously reduce radiation of heat away from the evaporation source, thereby reducing energy consumption and furthermore reducing the amount of heat radiated towards the substrate onto which the material is deposited, and/or towards adjacent components such as the supporting infrastructure of evaporation source 120 or other evaporation sources 120. Heat shield assemblies 280, 290 are detailed in the cross-section of Figure 2E.

Figure 2E is a schematic cross-sectional view of evaporation source 120 according to one embodiment. As in Figure 2C, evaporation source 120 may contain molten material 170 that may be heated by one or more heater assemblies 200 to become molten and/or to be evaporated within the evaporation region 166 of the crucible 160 that is enclosed by lid 164 and crucible base 168. The float 180 is disposed over material 170 such that molten material 170 resides at least partway into channels 182 through the float 180. Crucible 160 may also comprise at least one temperature sensor 271, 272 (see Figure 2D) and at least one temperature sensor channel 276, 277. Heat shield assemblies 280, 290 may comprise one or more shielding layers. In one embodiment, heat shield assemblies 280, 290 comprise three shielding layers. A person of ordinary skill in the art will infer that the number, size, thickness, and spacing of shields may vary. Lid heat shield assembly 280 may comprise inner shield 294, middle shield 295, and outer shield 296. Crucible heat shield assembly 290 may comprise inner shield 291, middle shield 292, and outer shield 293. Shields 294, 295, 296 may be spaced apart from one another by standoffs or insulation to improve thermal shielding. Similarly, shields 294, 295, 296 may not be in contact with one another to improve thermal shielding. Inner and outer shields 294, 296, 291, 293 may comprise high-temperature resistant material such as molybdenum, tantalum, tungsten, niobium, rhenium, or titanium. Middle shields 295, 292 may comprise a refractory material and may comprise or primarily contain alumina (Al₂O₃), silica, boron nitride, or felt made of carbon or graphite. In one embodiment, middle shields 292, 295 may be formed of a plurality of plates (not shown).

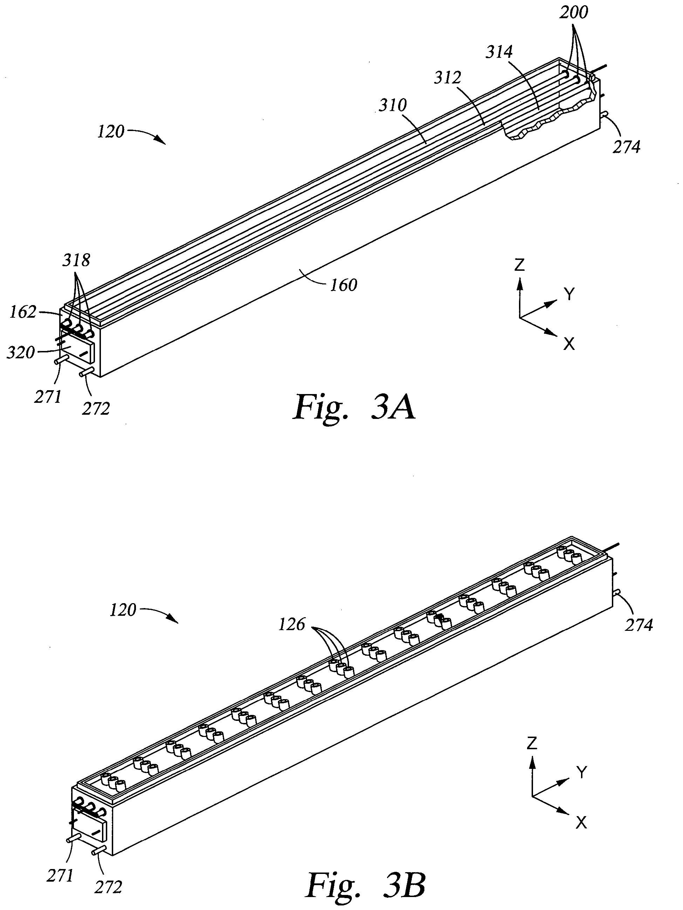

Figure 3A is a perspective view of the evaporation source 120 according to another embodiment. Evaporation source 120 comprises a crucible 160 that includes a heater assembly 200. In this configuration, the heater assembly 200 comprises two or more heating rods, such as the three heating rods 310, 312, 314 illustrated in Figures 3A-3D. The heating rods 310, 312, 314 may be positioned parallel to one another within crucible 160 and be supported at each end by electrically insulating support holes 318 that are formed through a wall 162 of the crucible 160. In one embodiment, heating rods 310, 312, 314 may be positioned close to the opening or top surface of crucible 160 so that there is no contact between heating rods 310, 312, 314 and material 170 contained in the crucible 160 during ordinary operation. In some cases, the heating rods 310, 312, 314 may be electrically connected in parallel and be powered via insulated contacts (not shown). A person of ordinary skill in the art will appreciate that the heating rods 310, 312, 314 may also be connected in series or in any combination of parallel and series, and that the number of heating rods positioned within crucible 160 may vary. Heating assembly 200 may further comprise one or more side heaters 220. Side heaters 320 may be mounted outside the crucible 160, such as against each short face of crucible 160. In the embodiment of Figures 2D and 2E, in which crucible 160 is surrounded by heat shields 291, 292, 293, 294, 295, 296, side heaters 320 may be positioned between the heat shields and the crucible 160 or within the crucible 160. Crucible 160 may also comprise one or more temperature sensors 271, 272. Temperature sensors 271, 272 may be positioned against or within the lower surface of crucible 160. Temperature sensor 271 may extend to the mid-length of heating rods 310, 312, 314. Temperature sensor 272 may extend at most one third of the length of heating rods 310, 312, 314.

Figure 3B is a perspective view of an evaporation source 120 according to another embodiment. The evaporation source 120 comprises a crucible 160 covered partially by a lid 164 that includes a plurality of outlets or nozzles 126 that are formed therein. In some embodiments, the lid 164 may include an array of outlets 126 that are disposed along the length of lid 164.

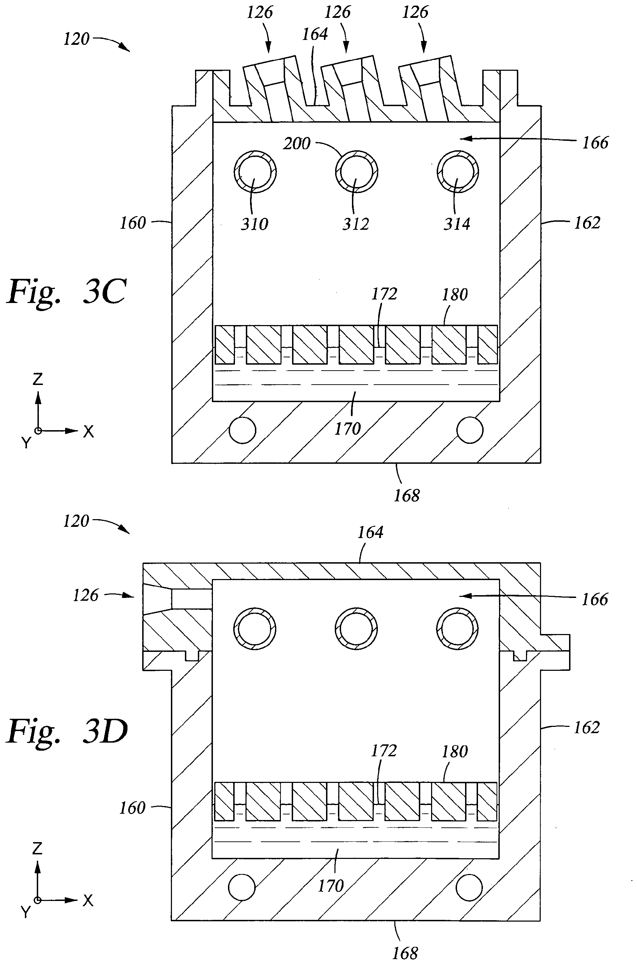

Figure 3C is a cross-sectional view of evaporation source 120 illustrated in Figures 3A-3B. The evaporation source 120 includes a lid 164 and crucible base 168 that enclose the evaporation region 166 that includes a float 180 that is disposed on an amount of material 170 that is heated by two or more heating assemblies 200. The heating rods 310, 312, 314 may be disposed in a parallel arrangement over the top surface of the float 180 and material 170 disposed in the crucible 160.

Figure 3D is a cross-sectional view of evaporation source 120 according to another embodiment. In this configuration, the evaporation source 120 includes a crucible 160 and lid 164 configuration in which one or more nozzles 126 have outlets through the side, rather than the top, of lid 164.

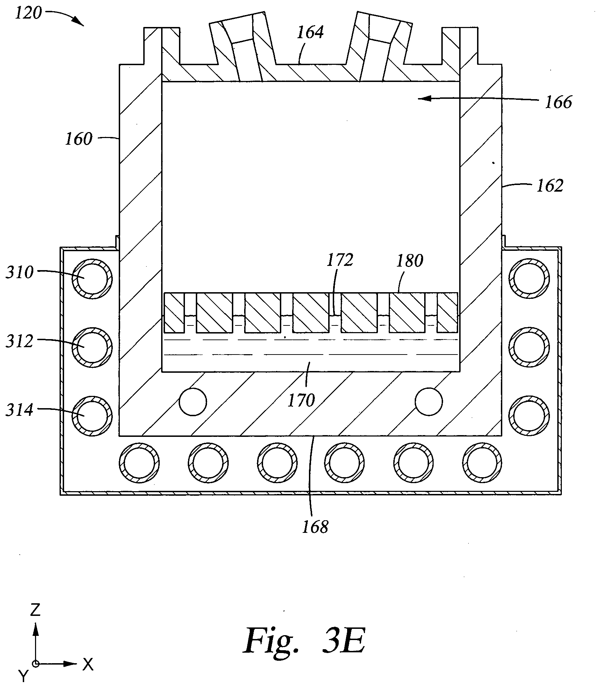

In some embodiments of the evaporation source 120, as illustrated in Figure 3E, the heating rods 310, 312, 314 may be disposed in or along the sides and/or bottom surfaces of the base 168 of the crucible 160. Such heating configuration eliminates the need for an electrical connection to heating rods inside crucible 160 and can provide for a more homogeneous heating of the material 170 disposed within the crucible 160.

As briefly discussed above, the float 180 may include a thermally conductive material that serves to reduce temperature variations across molten material 170. The float 180 includes a plurality of channels 182 that form openings that extend from the bottom surface of float 180 to the top surface of float 180. The channels 182 are sized and serve to regulate (via variations in the size of channels 182) the amount of effusion of molten material 170 from the surface. The optical absorption coefficient of the float 180 may be significantly higher than the optical absorption coefficient of the molten material 170. For example, the optical absorption coefficient of the float 180 may be about 0.75 or greater while a typical absorption coefficient of the molten material 170 may be about 0.15. The float 180 typically has a high thermal conductivity so that the energy transferred from the heating elements is transferred to the molten material 170. For example, the thermal conductivity of the material used to form the body 181 of the float 180 may be between about 20 W/m*K and about 50 W/m*K, or may be greater than 50 W/m*K. The float 180 is formed from a single material or a material that includes a coating. The float 180 includes graphite as a material with adequate absorption, stability, mass density, and thermal conductivity.

In a vapor deposition system 100 designed for fabrication of CIGS photovoltaic cells, the size of channels 182 in float 180 may vary depending on several parameters. In particular, the diameter of the channels 182 must be small enough so that stresses generated by gradients in temperature formed across the float 180 due to its contact with the heated material 170 and exposure to the thermal environment in the evaporation region 166 (e.g., heat from heating elements, etc.) will not cause the float 180 to crack. At the same time, the size of the cross-section of channels 182 must be large enough to allow enough molten material 170 to pass into channels 182 such that the evaporation flux 192 from the exposed surface of the material 170 is controlled to a desirable rate for a set vaporization temperature of the material 170 and pressure within the evaporation region 166. For example, the diameter of a cross-section of channels 182 may range from 0.3 mm to 1.5 mm. Similarly, the thickness of the float 180 must be small enough so that the aspect ratio of the channels 182 (i.e., diameter (or channel width) versus thickness) is large enough to provide stability of float 180 in molten material 170 and prevent clogging of the channels 182 due to solidification of the evaporating material 170. For example, channels 182 may have a depth (and float 180 may have a thickness) of 0.5 mm to 1.5 mm. In the invention, the diameter of a cross-section of channels 182 ranges from 2 mm to 10 mm, and the depth of channels 182 (and the thickness of float 180) ranges from 2 mm to 10 mm.

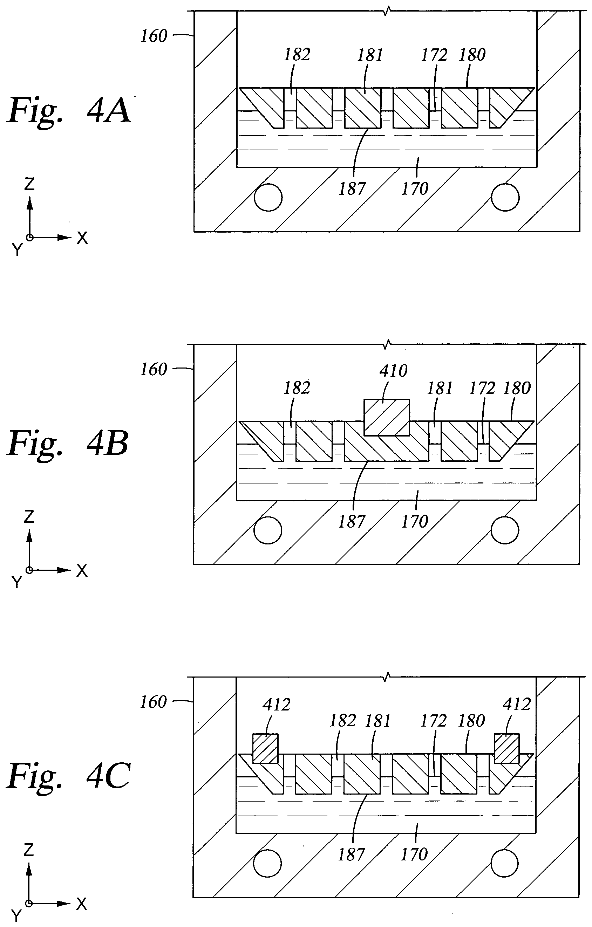

Figures 4A-4C are cross-sectional views of various configurations of the float 180 according to one or more embodiments of the disclosure provided herein. As shown in Figures 4A-4C, the float 180 comprises a plurality of channels 182 that are formed in the body 181. The lower surface 187 of the float 180 is in contact with the material 170 during processing, such that the molten material 170 at least partially fills the channels 182. In some configurations, the molten material 170 does not flood channels 182 completely, and thus the float 180 does not become submerged within the molten material 170. To achieve this outcome, mass density of the float 180 material may be selected so that the float has a desired buoyancy in the molten material 170. In some embodiments, as shown in Figures 4B and 4C, the float 180 may include a weight 410 or weights 412 that are used to adjust the mass per unit volume of the float 180 to ensure that the level of the molten material 170 relative to the body 181 of the float 180 is desirably set. For example, the weights 410, 412 may be adjusted to ensure that the lower surface 187 of the float completely contacts the molten material 170. In some embodiments, the additional weight 410 or weights 412 may be added to ensure that the float 180 does not rest on top of the material 170 but instead molten material 170 flows at least partially into channels 182 without fully submerging float 180. For example, the weight 410, 412 of the float 180 may be adjusted depending on which material 170 is being used in the crucible 160 and material that is being used to form the body 181 of the float 180. Therefore, in some embodiments, the total mass per unit volume of the float 180 is adjusted to match the mass density of the molten material 170. For example, if the molten material 170 is copper, density (mass per unit volume) of the float 180 is adjusted to be approximately 7.2 g/cm³ to 7.9 g/cm³ to allow the float 180 to have a neutral buoyancy in the molten material 170. Alternatively, the molten material 170 may be liquid indium, and the mass per unit volume of the float 180 is adjusted to approximately 6.9 g/cm³ to 7.1 g/cm³ (depending on the precise temperature). Alternatively, molten material 170 may be liquid gallium, and the mass per unit volume of the float 180 is adjusted to approximately 5.3 g/cm³ to 6.1 g/cm³ (depending on the precise temperature). A person of ordinary skill in the art will appreciate that the density of alternative molten materials will similarly vary in density, thus the weight of float 180 may be adjusted to ensure that float 180 maintains proper contact with molten material 170. As noted above, in some configurations, it is desirable to adjust the mass per unit volume of the float 180 so that it is not fully submerged within molten material 170 during processing. For example, the density of the float 180 may be between about 20 % to about 90 %, preferably between about 50 % to about 80 %, of the density of the molten material 170. If the molten material 170 is copper, the density of the float 180 may be between about 1.4 g/cm³ to about 7.9 g/cm³, preferably between about 3.2 g/cm³ to about 6.8 g/cm³. If the molten material 170 is indium, the density of the float 180 may be between about 1.3 g/cm³ to about 7.1 g/cm³, preferably between about 3.1 g/cm³ to about 5.0 g/cm³. If the molten material 170 is gallium, the density of the float 180 may be between about 1 g/cm³ to about 6.1 g/cm³, preferably between about 2.9 g/cm³ to about 4.7 g/cm³.

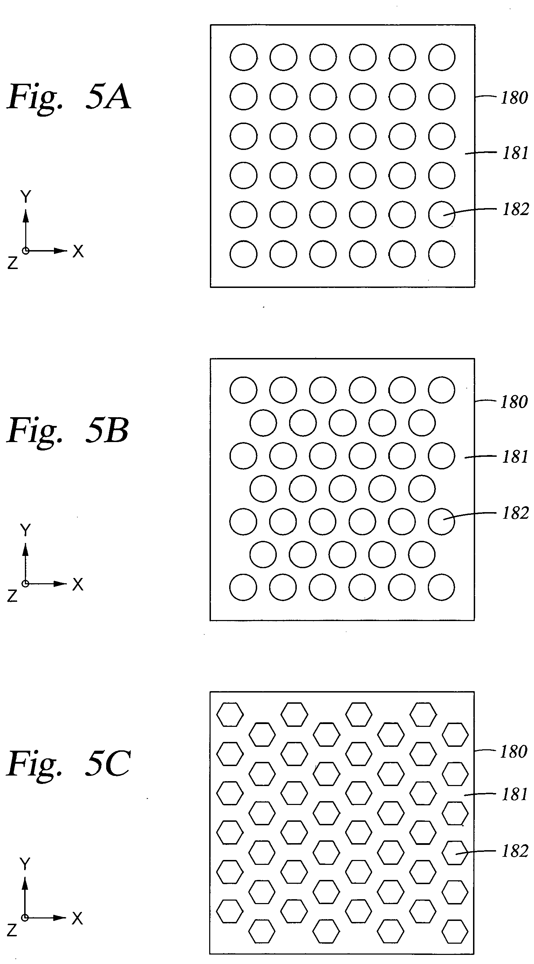

In one embodiment shown in Figure 5A, channels 182 are arranged in a rectangular array that includes regular rows and columns of channels 182, wherein the rows are generally parallel to one side of float 180 and the columns are generally perpendicular to that side of float 180. The rectangular array of channels is simple to fabricate and provide direct paths that allow lateral conduction (i.e., X and Y plane) heat through the float 180. By adjusting the position of the channels 182 within the rectangular array of channels 182 in the float 180, the exposed area of the surface of the material 170 during processing is limited and controlled to provide a desirable evaporation flux 192 or a deposition flux 190 (see Figure 1B) at a controlled material vaporization temperature and set chamber pressure. The diameter of the channels 182 must be small enough to prevent cracking due to thermal stress on the float 180 caused by solidification of the molten metal as it cools.

Figure 5B is a top view of float 180 according to another embodiment. In this configuration, the channels 182 are arranged in hexagonal close-pack type array. In this configuration, the open area of the channels 182, or hole density, can be increased over the rectangular array shown in Figure 5A, and the heat transfer path between portions of material 170 disposed within the channels 182 during processing will be reduced. Reducing the heat transfer path, or lateral conduction length, through the float 180 may be useful where the thermal conductivity of the float material is less than the thermal conductivity of the molten material 170. Such an arrangement provides greater stability than the arrangement in Figure 5A.

Figure 5C is a top view of a float 180 according to another embodiment. In this configuration, the channels 182 are disposed similarly to the hexagonal array illustrated in Figure 5B, except that the channels 182 include a polygonal cross-section, such as a hexagonal cross-section. Such a design provides greater stability than a channel 182 that has a circular cross-section. Further, such a design allows for greater channel density, or open area, to be achieved within the float 180. Such an arrangement also provides shorter heat transfer paths between channels 182 than the configurations shown in Figures 5A and 5B. A person of ordinary skill in the art will understand that one could combine the polygonal cross-section of channels 182 in Figure 5C with the regular channel arrangement of Figure 5A to simplify fabrication, and that other combinations will also be possible.

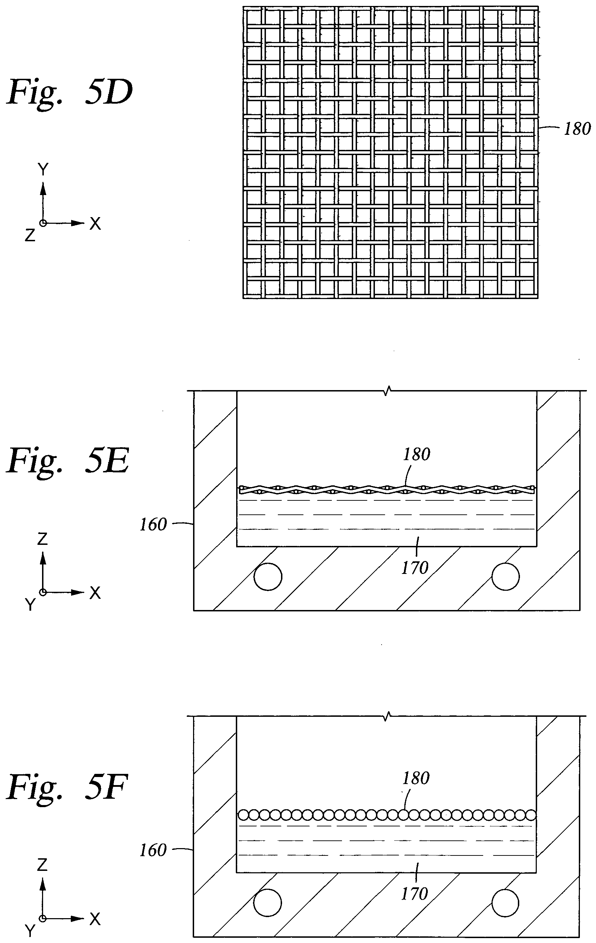

A person of ordinary skill in the art will appreciate that the float 180 may take other forms, not according to the present invention. For example, in Figure 5D, the float 180 may comprise a woven or fibrous material with a certain mass density that allows the float 180 to reside on the surface of the molten material 170. Figure 5E shows a cross-section of the woven arrangement of the embodiment of the float 180 pictured in Figure 5D. Alternatively, in Figure 5F, the float 180 may comprise a set of spheres that form at least a layer on the surface of the molten material 170. In this case, the set of spheres may be positioned on the material 170, and/or coupled together, in a rectangular array type pattern formed in the X-Y plane to control the open area of the formed "channels" in the float 180. Alternatively, the spheres may be positioned on the material 170, and/or coupled together, in a hexagonal close-packed array type pattern formed in the X-Y plane. The rectangular array configuration might provide, for example, a float 180 that has channels that have a 21% open area for the molten material 170 to effuse through during processing. The hexagonal close-packed array configuration might provide a float 180 that has channels that have a 9% open area for the molten material 170 to effuse through during processing. It is believed that the hexagonal array configuration of spheres will provide a more homogeneous flux distribution (e.g., across the X-Y plane), which can be useful to assure that the evaporation flux 192 or the deposition flux 190 (see Figure 1B) is desirably controlled and uniform across the evaporation source. In some embodiments, the mass density of the spheres may be selected so that the mass density is at least less than half the mass density of the molten material 170. In another case, the mass density of the spheres can be adjusted so that the open area of the formed channels, which the evaporation flux will pass through, is set at a desirable level. In one example, the mass density of the spheres is adjusted so that the mass density is at least half of the molten material 170 so that the open area of the formed channels is increased.

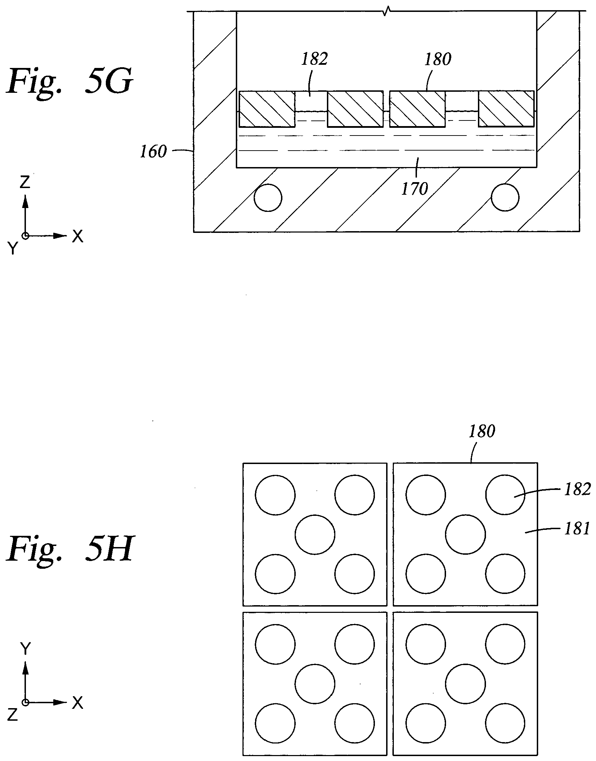

Alternatively, in Figure 5G, the float 180 may comprise a set of independent islands or tiles of a given shape, a layer of which floats on the surface of the molten material 170. As shown in Figure 5H, each of the independent islands or tiles may feature channels 182 like those illustrated in Figures 5A-5C. These alternative configurations for the float 180 may be fabricated from the same material or materials as the float 180 described above. In some configurations, the mass density of each of the independent islands is selected so that they rest on the surface of molten material 170. A person of ordinary skill in the art will appreciate that the float 180 may comprise a combination of more than one of these arrangements, such as the independent islands of Figures 5G-5H combined with the woven arrangement of Figures 5D-5E, in order to prevent overlapping and increase homogeneity.

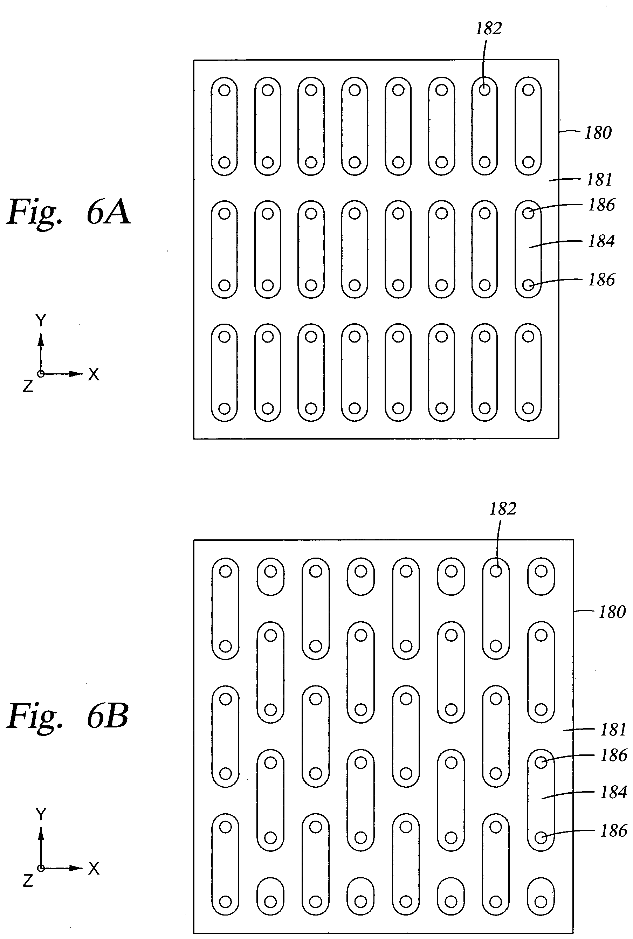

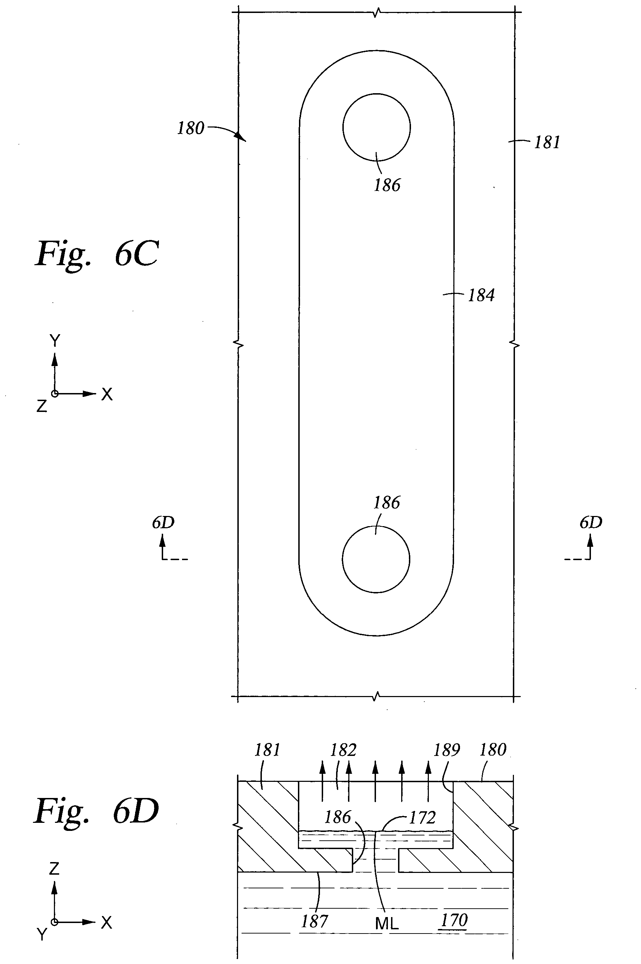

Figures 6A-6D illustrate various features of another embodiment of the float 180, not according to the present invention. Figures 6A and 6B illustrate two different configurations of a float 180, each of which includes a multifaceted channel 182. In one embodiment, the multifaceted channel 182 includes an elongated well 184 and a plurality of connection channels 186 that extend through the elongated well 184 and the opposing surface of the float 180. As illustrated in Figure 6C, in one embodiment, the multifaceted channel 182 includes two connection channels 186 that are paired in a single elongated well 184. As shown in Figure 6D, which is created from a section line 6D-6D illustrated in Figure 6C, the connection channel 186 is narrower than the elongated well 184 and extends between the lower surface 187 of the float 180 to the inner surface 189 of the elongated well 184. During processing, the lower surface 187 of the channel 186 is in contact with the material 170 in the crucible 160, and molten material 170 may flow into channel 186 and further into a portion of the elongated well 184. In one example, the weight of the float 180 may be adjusted so that the molten material 170 may flow into channel 186 and into a portion of the elongated well 184 up to a level "ML", as shown in Figure 6D. Use of the channels 186 in elongated well 184 increases the surface area exposure of the molten material 170 and allows for more uniform heating and distribution of material 170. As shown in Figures 6A and 6B, elongated wells 184 are aligned lengthwise on float 180 (e.g., aligned in Y-direction). Figure 6A shows elongated wells 184 also aligned in a regular rectangular array of channels 182 that are arranged in rows and columns on float 180. Alternatively, as in Figure 6B, the channels 182 are aligned lengthwise in a staggered array type pattern, which may provide greater thermal stability and uniform effusion rate across the surface of the float. The regular rectangular array of channels 182 of Figure 6A is easier to fabricate, but the staggered array of channels 182 of Figure 6B provides more uniform exposure of molten material 170, resulting in more uniform effusion. The wells 184 further allow control over the surface area of the molten material 170 that is exposed for evaporation independent from the cross-sectional area of the interior of the crucible 160. The cross-sectional area of the interior of the crucible 160 can often change at different heights within the crucible 160, so the wells 184 can provide a constant surface area for the molten material to evaporate from independent from the height of the molten material 170 within the crucible 160. Furthermore, the floats 180 can easily be interchanged, so that the a first float 180 having a first set of wells 184 providing a first surface area for the molten material 170 to evaporate can be replaced with a second float 180 having a first set of wells 184 providing a first surface area for the molten material 170 to evaporate. Thus, by using different floats 180 with different arrangements of wells 184, a user can precisely tailor the surface area of molten material 170 that is exposed for evaporation enhancing the control the user has over the deposition process.

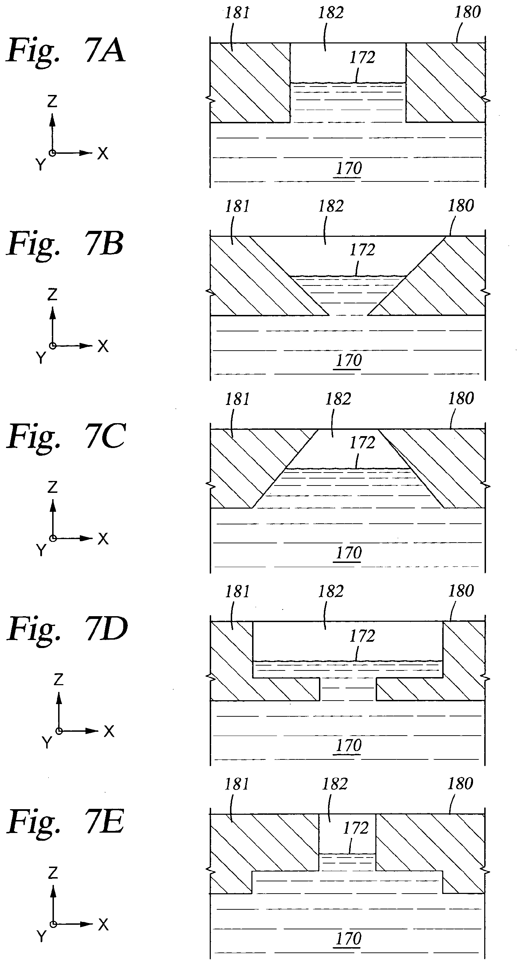

Figures 7A-7E are cross-sectional views of a channel 182 or 186 according to several embodiments. In each of these embodiments, channel 182 may have a circular, or polygonal shape. Figure 7A shows a cross-sectional view of channel 182 of uniform diameter. Figure 7B shows a cross-sectional view of a channel 182 with a conical frustum shape, wherein the narrower end of the frustum contacts the material 170 and the wider end of the frustum faces the top surface of the float 180. Figure 7C shows a cross-sectional view of a channel 182 with a conical frustum shape, wherein the wider end of the conical frustum contacts the material 170 and the narrower end of the conical frustum faces the top surface of float 180. Figure 7D shows a cross-sectional view of channel 182 with a stepped shape in which the smaller diameter end faces material 170 and the larger diameter end faces the top surface of float 180. Figure 7E shows a cross-sectional view of channel 182 with a stepped shape in which the larger diameter end contacts material 170 and the smaller diameter end faces the top surface of float 180.

## Claims

1. An evaporation source (120), comprising:
a crucible (160) adapted to enclose an amount of a material (170), wherein the crucible comprises a lid (164) that comprises one or more nozzles (126) ;
a heating element (200) adapted to heat the material to a molten state; and
a float (180) adapted to remain on the surface (172) of the molten material (170),
wherein the float (180) comprises graphite and comprises a plurality of channels (182) that extend from the bottom surface of the float (180) to the top surface of the float (180) wherein a diameter of a cross-section of the channels (182) ranges from 2 mm to 10 mm and the depth of the channels (182) ranges from 2 mm to 10 mm so that stresses generated by gradients in temperature formed across the float (180) will not cause the float (180) to crack.

2. The evaporation source of claim 1, wherein the channels (182) have a circular cross-section.

3. The evaporation source of claim 1, wherein the channels (182) have a polygonal cross-section.

4. The evaporation source of claim 1, wherein the channels (182) are arranged in a rectangular array.

5. The evaporation source of claim 1, wherein the channels (182) are arranged in a hexagonal array.

6. The evaporation source of claim 1, wherein the channels (182) are arranged in one or more rows, wherein the one or more rows are substantially parallel to a side of the float (180).

7. The evaporation source of claim 6, wherein alternating rows are staggered.

8. The evaporation source of claim 1, wherein the float (180) has a thickness in a range from 2 mm to 10 mm.

9. A method of depositing a layer on a substrate (130), comprising:
evaporating a material (170) that is disposed between a float (180) and a base (168) of a crucible (160), wherein evaporating the material comprises:
heating the material (170) to a molten state and a vaporization temperature, wherein heating the material generates a flux (192) of the material that flows through a plurality of channels (182) formed in the float (180); and
passing a substrate (130) over one or more nozzles (126) of the crucible (160), wherein the one or more nozzles are positioned to receive at least portion of the flux (192) of the material that flows through the plurality of channels (182), wherein the float (180) comprises graphite and comprises a plurality of channels (182) that extend from the bottom surface of the float (180) to the top surface of the float (180) wherein a diameter of a cross-section of the channels (182) ranges from 2 mm to 10 mm and the depth of the channels (182) ranges from 2 mm to 10 mm so that stresses generated by gradients in temperature formed across the float (180) will not cause the float (180) to crack.

10. The method of claim 9, further comprising adjusting a weight of the float (180) such that a surface of the float (180) completely contacts the molten material.

## Patentansprüche

1. Verdampfungsquelle (120), umfassend:
einen Tiegel (160), der angepasst ist, um eine Menge eines Materials (170) einzuschließen, wobei der Tiegel einen Deckel (164) umfasst, der eine oder mehrere Düsen (126) umfasst;
ein Heizelement (200), das angepasst ist, um das Material in einen geschmolzenen Zustand zu erwärmen; und
einen Schwimmer (180), der angepasst ist, um auf der Oberfläche (172) des geschmolzenen Materials (170) zu bleiben,
wobei der Schwimmer (180) Graphit beinhaltet und mehrere Kanäle (182) umfasst, die sich von der Bodenfläche des Schwimmers (180) zur Oberseite des Schwimmers (180) erstrecken, wobei der Querschnitt der Kanäle (182) einen Durchmesser von 2 mm bis 10 mm aufweist und die Tiefe der Kanäle (182) von 2 mm bis 10 mm reicht,
so dass Spannungen, die durch Temperaturgradienten erzeugt werden und sich über dem Schwimmer (180) bilden, nicht dazu führen, dass der Schwimmer (180) reißt.

2. Verdampfungsquelle nach Anspruch 1, wobei die Kanäle (182) einen kreisförmigen Querschnitt haben.

3. Verdampfungsquelle nach Anspruch 1, wobei die Kanäle (182) einen polygonalen Querschnitt haben.

4. Verdampfungsquelle nach Anspruch 1, wobei die Kanäle (182) in einer rechteckigen Anordnung angeordnet sind.

5. Verdampfungsquelle nach Anspruch 1, wobei die Kanäle (182) in einer hexagonalen Anordnung angeordnet sind.

6. Verdampfungsquelle nach Anspruch 1, wobei die Kanäle (182) in einer oder mehreren Reihen angeordnet sind, wobei eine oder mehrere Reihen im Wesentlichen parallel zu einer Seite des Schwimmers (180) sind.

7. Verdampfungsquelle nach Anspruch 6, wobei die Reihen abwechselnd versetzt sind.

8. Verdampfungsquelle nach Anspruch 1, wobei der Schwimmer (180) eine Dicke in einem Bereich von 2 mm bis 10 mm aufweist.

9. Verfahren zum Abscheiden einer Schicht auf einem Substrat (130), umfassend:
Verdampfen eines Materials (170), das zwischen einem Schwimmer (180) und einer Basis (168) eines Tiegels (160) angeordnet ist, wobei das Verdampfen des Materials umfasst:
Erhitzen des Materials (170) bis zu einem geschmolzenen Zustand und einer Verdampfungstemperatur, wobei das Erhitzen des Materials einen Fluss (192) des Materials erzeugt, der durch mehrere Kanäle (182) fließt, die in dem Schwimmer (180) ausgebildet sind; und
Durchführen eines Substrats (130) über eine oder mehrere Düsen (126) des Tiegels (160), wobei die eine oder mehreren Düsen so positioniert sind, dass sie mindestens einen Teil des Flusses (192) des Materials aufnehmen, das durch die Vielzahl von Kanälen fließt (182),
wobei der Schwimmer (180) Graphit beinhaltet und mehrere Kanäle (182) umfasst, die sich von der Bodenfläche des Schwimmers (180) zur Oberseite des Schwimmers (180) erstrecken, wobei der Querschnitt der Kanäle (182) einen Durchmesser von 2 mm bis 10 mm aufweist (182) und die Tiefe der Kanäle (182) von 2 mm bis 10 mm reicht,
so dass Spannungen, die durch Temperaturgradienten erzeugt werden, die sich über dem Schwimmer (180) bilden, nicht dazu führen, dass der Schwimmer (180) reißt.

10. Verfahren nach Anspruch 9, ferner das Einstellen eines Gewichts des Schwimmers (180) beinhaltend, so dass eine Oberfläche des Schwimmers (180) das geschmolzene Material vollständig berührt.

## Revendications

1. Source d'évaporation (120), comprenant:
un creuset (160) adapté pour renfermer une quantité d'un matériau (170), dans lequel le creuset comprend un couvercle (164) qui comprend une ou plusieurs buses (126);
un élément chauffant (200) adapté pour chauffer le matériau à un état fondu; et
un flotteur (180) adapté pour rester à la surface (172) du matériau fondu (170),
dans lequel le flotteur (180) comprend du graphite et comprend une pluralité de canaux (182) qui s'étendent de la surface inférieure du flotteur (180) à la surface supérieure du flotteur (180) dans lequel un diamètre d'une section transversale des canaux (182) varie de 2 mm à 10 mm et la profondeur des canaux (182) varie de 2 mm à 10 mm
de sorte que les contraintes générées par les gradients de température formés à travers le flotteur (180) ne provoquent pas la fissuration du flotteur (180).

2. Source d'évaporation selon la revendication 1, dans laquelle les canaux (182) ont une section transversale circulaire.

3. Source d'évaporation selon la revendication 1, dans laquelle les canaux (182) ont une section transversale polygonale.

4. Source d'évaporation selon la revendication 1, dans laquelle les canaux (182) sont disposés en un réseau rectangulaire.

5. Source d'évaporation selon la revendication 1, dans laquelle les canaux (182) sont disposés en un réseau hexagonal.

6. Source d'évaporation selon la revendication 1, dans laquelle les canaux (182) sont disposés en une ou plusieurs rangées, dans laquelle la ou les rangées sont sensiblement parallèles à un côté du flotteur (180).

7. Source d'évaporation selon la revendication 6, dans laquelle des rangées alternées sont décalées.

8. Source d'évaporation selon la revendication 1, dans laquelle le flotteur (180) a une épaisseur comprise entre 2 mm et 10 mm.

9. Procédé de dépôt d'une couche sur un substrat (130), comprenant:
évaporer un matériau (170) qui est disposé entre un flotteur (180) et une base (168) d'un creuset (160), dans lequel l'évaporation du matériau comprend:
chauffer le matériau (170) jusqu'à un état fondu et une température de vaporisation, dans lequel le chauffage du matériau génère un flux (192) du matériau qui s'écoule à travers une pluralité de canaux (182) formés dans le flotteur (180); et
passer un substrat (130) sur une ou plusieurs buses (126) du creuset (160), dans lequel la ou les buses sont positionnées pour recevoir au moins une partie du flux (192) du matériau qui s'écoule à travers la pluralité de canaux (182),
dans lequel le flotteur (180) comprend du graphite et comprend une pluralité de canaux (182) qui s'étendent de la surface inférieure du flotteur (180) à la surface supérieure du flotteur (180) dans lequel un diamètre d'une section transversale des canaux (182) varie de 2 mm à 10 mm et la profondeur des canaux (182) varie de 2 mm à 10 mm
de sorte que les contraintes générées par les gradients de température formés à travers le flotteur (180) ne provoquent pas de fissuration du flotteur (180).

10. Procédé selon la revendication 9, comprenant en outre l'ajustement d'un poids du flotteur (180) de telle sorte qu'une surface du flotteur (180) entre complètement en contact avec le matériau fondu.
